(19) Europäisches Patentamt
European Patent Office
Office européen des brevets

(11) EP 2 313 934 B1

(12) EUROPÄISCHE PATENTSCHRIFT

(45) Veröffentlichungstag und Bekanntmachung des Hinweises auf die Patenterteilung:
17.01.2018 Patentblatt 2018/03

(21) Anmeldenummer: 09775997.1

(22) Anmeldetag: 21.07.2009

(51) Int Cl.:
H01L 21/02 (2006.01)      H01S 5/042 (2006.01)
H01L 33/24 (2010.01)      H01L 33/00 (2010.01)
H01S 5/223 (2006.01)      H01L 31/0236 (2006.01)
H01S 5/32 (2006.01)       H01S 5/20 (2006.01)
H01S 5/24 (2006.01)

(86) Internationale Anmeldenummer:
PCT/DE2009/001023

(87) Internationale Veröffentlichungsnummer:
WO 2010/012266 (04.02.2010 Gazette 2010/05)

(54) **HERSTELLUNGSVERFAHREN FÜR EINEN III-V BASIERTEN INDIUM- HALTIGEN OPTOELEKTRONISCHEN HALBLEITERCHIP UND ENTSPRECHENDER CHIP**

PRODUCTION METHOD FOR A III-V BASED OPTOELECTRONIC SEMICONDUCTOR CHIP CONTAINING INDIUM AND CORRESPONDING CHIP

PROCÉDÉ DE FABRICATION D'UNE PUCE OPTOÉLECTRONIQUE À BASE DE SEMI-CONDUCTEURS III-V CONTENANT DE L'INDIUM ET PUCE CORRESPONDANTE

(84) Benannte Vertragsstaaten:
AT BE BG CH CY CZ DE DK EE ES FI FR GB GR HR HU IE IS IT LI LT LU LV MC MK MT NL NO PL PT RO SE SI SK SM TR

(30) Priorität: 31.07.2008 DE 102008035784

(43) Veröffentlichungstag der Anmeldung:
27.04.2011 Patentblatt 2011/17

(73) Patentinhaber: Osram Opto Semiconductors Gmbh
93055 Regensburg (DE)

(72) Erfinder:
• LUTGEN, Stephan
93047 Regensburg (DE)
• EICHLER, Christoph
93105 Tegernheim (DE)
• SCHILLGALIES, Marc
10961 Berlin (DE)
• QUEREN, Désirée
93073 Neutraubling (DE)

(74) Vertreter: Epping - Hermann - Fischer
Patentanwaltsgesellschaft mbH
Schloßschmidstraße 5
80639 München (DE)

(56) Entgegenhaltungen:
EP-A2- 1 901 357       WO-A1-2007/003684
US-A1- 2005 001 227    US-A1- 2005 045 894
US-A1- 2005 082 544    US-A1- 2008 149 946

**Beschreibung**

Die vorliegende Anmeldung betrifft einen optoelektronischen Halbleiterchip und ein Verfahren zur Herstellung eines optoelektronischen Halbleiterchips.

Diese Patentanmeldung beansprucht die Priorität der deutschen Patentanmeldung 10 2008 035 784. 7. Zur Erzeugung von Strahlung mit einer Wellenlänge im kurzwelligen sichtbaren oder ultravioletten Spektralbereich sind Halbleiterchips aus Nitridverbindungshalbleitern aufgrund der relativ großen Bandlücke von Nitridverbindungshalbleitern besonders geeignet.

Gitterfehlanpassungen innerhalb des Halbleiterchips, beispielsweise zwischen Aufwachssubstrat und aufgewachsenen Schichten, können Verspannungen verursachen, die im Falle von Indium-haltigen Nitridverbindungshalbleitern zu räumlichen Fluktuationen des Indiums führen können, was sich auf die Kristallqualität des Halbleiterchips negativ auswirkt.

In der Druckschrift US 2006/0060833 A1 ist ein strahlungsemittierendes optoelektronisches Bauelement mit einer aktiven Zone beschrieben, die eine Quantentopfstruktur aufweist, die mindestens ein erstes Nitridverbindungshalbleitermaterial enthält, wobei die Quantentopfstruktur auf mindestens einer Seitenfacette einer nicht planaren Struktur, die mindestens ein zweites Nitridverbindungshalbleitermaterial enthält, aufgewachsen ist. Die nicht planare Struktur wird mit Hilfe einer Maskenschicht erzeugt, die beispielsweise ein Siliziumoxid oder Siliziumnitrid enthält. Durch das Aufwachsen der Quantentopfstruktur auf eine Seitenfacette sollen durch Gitterfehlanpassungen verursachte piezolelektrische Felder verringert und die Homogenität der Quantentopfstruktur verbessert werden.

Weitere Halbleiterstrukturen, bei welchen Halbmaterial auf eine unebene Aufwachsschicht aufgebracht ist, sind in den Druckschriften US 2008/0149946, WO 2007/003684, EP 1901357 und US 2005/0082544 beschrieben.

Aus der Druckschrift US 2005/0045894 A1 ist ein lichtemittierendes Halbleiterbauteil und ein Herstellungsverfahren hierfür bekannt, bei dem eine lichterzeugende Halbleiterschicht auf eine strukturierte GaN-Schicht aufgebracht wird.

Eine zu lösende Aufgabe besteht vorliegend darin, einen optoelektronischen Halbleiterchip mit verbesserter Kristallqualität anzugeben.

Diese Aufgabe wird durch einen optoelektronischen Halbleiterchip gemäß Patentanspruch 1 gelöst.

Eine weitere zu lösende Aufgabe besteht darin, ein effizientes Verfahren zur Herstellung eines derartigen optoelektronischen Halbleiterchips anzugeben.

Diese Aufgabe wird durch ein Verfahren gemäß Patentanspruch 11 gelöst.

Vorteilhafte Ausgestaltungen und Weiterbildungen des optoelektronischen Halbleiterchips und des Verfahrens zur Herstellung eines optoelektronischen Halbleiterchips sind Gegenstand der abhängigen Patentansprüche.

Gemäß einer Ausführungsform umfasst der optoelektronische Halbleiterchip eine nicht planare Aufwachsschicht, die mindestens ein erstes Nitridverbindungshalbleitermaterial enthält, sowie eine aktive Zone, die mindestens ein zweites Nitridverbindungshalbleitermaterial enthält und auf der Aufwachsschicht angeordnet ist, und eine Deckschicht, die auf der aktiven Zone angeordnet ist, wobei die Aufwachsschicht an einer der aktiven Zone zugewandten Aufwachsoberfläche Strukturelemente aufweist.

Die Aufwachsschicht kann durchgehend ausgebildet sein oder Unterbrechungen aufweisen, wobei sie in den Ausführungsbeispielen durchgehen ist. Beispielsweise kann die Aufwachsschicht mittels Strukturierung einer planaren Schicht hergestellt werden. Die erzeugten Strukturelemente können aus dem gleichen Material wie die Aufwachsschicht gebildet sein und mindestens ein erstes Nitridverbindungshalbleitermaterial enthalten, das sich von dem in der aktiven Zone enthaltenen zweiten Nitridverbindungshalbleitermaterial unterscheidet.

Ein Wachstum der aktiven Zone kann auf den Strukturelementen und/oder in den Zwischenräumen zwischen den Strukturelementen stattfinden. Die Aufwachsoberfläche der vorliegend beschriebenen nicht planaren Aufwachsschicht ist größer als die Oberfläche einer planaren Schicht. Mittels der vergrößerten Aufwachsoberfläche kann die Verspannung reduziert und damit die Defektbildung verringert werden, wodurch wiederum nichtstrahlende Rekombination seltener auftritt und damit die Lichtausbeute erhöht werden kann.

Die Deckschicht kann ein Halbleitermaterial wie beispielweise AlGaAs enthalten.

Bei einer Ausführungsform enhält die Deckschicht ein transparents leitendes Oxid oder besteht daraus. Durch die Deckschicht aus einem transparenten leitenden Oxid können Verspannungen gegenüber einer Schicht aus Halbleitermaterial verringert und somit die Materialqualität verbessert werden. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, $SnO_2$ oder $In_2O_3$ gehören auch ternäre Metallsauerstoffverbindungen, wie beispielsweise $Zn_2SnO_4$, CdSnO3, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Durch die Deckschicht, die ein transparentes leitendes Oxid enthält, kann die in der aktiven Zone erzeugte Strahlung aus dem Halbleiterchip ausgekoppelt werden. Ferner kann mittels einer derartigen Deckschicht in den optoelektronischen Halbleiterchip Strom eingeprägt werden. Insbesondere ist die Deckschicht auf der p-dotierten Seite des Halbleiterchips angeordnet.

Die Deckschicht kann auf eine darunter liegende Schicht eines ersten Halbleiterbereichs aufgedampft oder aufgesputtert werden. Der erste Halbleiterbereich ist zwischen der aktiven Zone und der Deckschicht angeordnet und weist vorzugsweise eine Dicke zwischen mindestens 2 nm und höchstens 300 nm auf. Die relativ geringe Dicke des ersten Halbleiterbereichs trägt zu einer Verringerung der Verspannungen im Halbleiterchip bei.

Im Falle eines Laserdiodenchips dient die Deckschicht beispielsweise als Mantelschicht, die eine Mantelschicht aus Halbleitermaterial ersetzt. Mittels der Mantelschicht kann die optische Welle im Laserdiodenchip lateral geführt und gleichzeitig von Metallkontakten mit hohen Extinktionskoeffizienten an der Oberseite des Laserdiodenchips abgeschirmt werden. Dadurch können interne Verluste des Lasersdiodenchips reduziert werden. Für die Deckschicht wird ein TCO gewählt, das einen kleineren Brechungsindex aufweist als der erste Halbleiterbereich, so dass durch die Deckschicht eine gute Wellenführung und Abschirmung von den Metallkontakten gewährleistet ist.

Für das Wachstum herkömmlicher Deckschichten oder p-dotierter Mantelschichten aus Halbleitermaterial sind relativ hohe Temperaturen von typischerweise mehr als 1000°C und relativ lange Wachstumszeiten von mehr als einer Stunde nötig. Dies kann bei hohem Indiumgehalt in der aktiven Zone zu einer Diffusion von Indium und damit zu einer Minderung der Kristallqualität und Veränderung der Wellenlänge führen. Vorteilhafterweise können durch die Verwendung einer TCO enthaltenden Deckschicht die Wachstumstemperatur abgesenkt und die Wachstumszeit verkürzt und die Degradation der aktiven Zone verringert werden. Insbesondere kann die Deckschicht aus TCO bei einer Temperatur von höchstens 950°C, vorzugsweise höchstens 900°C, besonders bevorzugt höchstens 300°C, hergestellt werden. Die nicht planare Geometrie der Aufwachsschicht setzt sich bis in die aktive Zone fort, das heißt die aktive Zone weist insbesondere eine durch die Aufwachsschicht beziehungsweise die Strukturelemente bestimmte nicht planare Gestalt auf. Die Aufwachsschicht kann unmittelbar an die aktive Zone angrenzen oder durch Zwischenschichten von der aktiven Zone beabstandet sein. Mit Vorteil ist der Abstand einerseits so groß gewählt, dass durch die Strukturelemente keine Beschädigungsgefahr für die aktive Zone besteht, und ist andererseits so klein gewählt, dass sich die nicht planare Geometrie bis in die aktive Zone fortsetzt. Die aktive Zone ist mit Vorteil eine durchgehende Schicht, welche die Aufwachsoberfläche überdeckt. Typischeweise umfasst die aktive Zone mehrere Teilschichten.

Während die Aufwachsschicht an der Aufwachsoberfläche Strukturelemente aufweist und somit auf der Seite der Aufwachsoberfläche nicht planar ist, ist sie auf einer der Aufwachsoberfläche gegenüber liegenden Seite planar ausgebildet.

Durch die nicht planare Geometrie der Aufwachsoberfläche weist auch die auf der Aufwachsoberfläche angeordnete aktive Zone eine nicht planare Geometrie auf. Insbesondere sind sowohl eine der Aufwachsoberfläche zugewandte Oberfläche als auch eine der Aufwachsoberfläche abgewandte Oberfläche der aktiven Zone nicht planar ausgebildet.

Die aktive Zone weist zur Strahlungserzeugung einen pn-Übergang auf. Dieser pn-Übergang kann im einfachsten Fall mittels einer p-leitenden und einer n-leitenden Halbleiterschicht gebildet sein, die unmittelbar aneinandergrenzen. Bevorzugt ist zwischen der p-leitenden und der n-leitenden Schicht die eigentliche Strahlung erzeugende Struktur, etwa in Form einer dotierten oder undotierten Quantenstruktur, ausgebildet. Die Quantenstruktur kann als Einfachquantentopfstuktur (SQW, Single Quantum Well) oder Mehrfachquantentopfstruktur (MQW, Multiple Quantum Well) oder auch als Quantendraht oder Quantenpunktstruktur ausgebildet sein.

Gemäß einer bevorzugten Ausführungsform ist das zweite Nitridverbindungshalbleitermaterial, das in der aktiven Zone enthalten ist, ein $In_{1-x-y}Al_xGa_yN$ mit $0 \leq x < 1$, $0 \leq y < 1$ und $1-x-y \geq 0{,}15$. Der Indiumanteil von mindestens 15% ermöglicht die Erzeugung von Strahlung mit einer Wellenlänge im kurzwelligen sichtbaren Spektralbereich. Insbesondere weist die von der aktiven Zone emittierte Strahlung eine Wellenlänge $\lambda$ von 435 nm oder größer auf. Besonders bevorzugt ist der vorliegend beschriebene optoelektronische Halbleiterchip zur Emission von grünem Licht vorgesehen.

Vorzugsweise ist das erste Nitridverbindungshalbleitermaterial, das in der Aufwachsschicht enthalten ist, ein $In_{1-x-y}Al_xGa_yN$ mit $0 \leq x \leq 1$, $0 \leq y \leq 1$ und $x+y \leq 1$. Insbesondere weist die Aufwachsschicht einen geringeren Indiumgehalt auf als die aktive Zone. Bevorzugte Materialien für die Aufwachsschicht sind Galliumnitrid oder Indiumgalliumnitrid.

Die Höhe der Strukturelemente kann Werte von wenigen Nanometern bis zu einigen hundert Nanometern annehmen. Die Breite der Strukturelemente kann in der Größenordnung von wenigen Nanometern bis zu einigen Mikrometern liegen.

Bei einer vorteilhaften Ausgestaltung des optoelektronischen Halbleiterchips weisen die Strukturelemente eine Höhe und Breite im Bereich von $\lambda/n$, vorzugsweise von höchstens $\lambda/n$, auf. Vorteilhaftweise können hierdurch optische Streuverluste an der Grenze zwischen der aktiven Zone und der Aufwachsschicht verringert werden.

Unter der "Höhe" ist die längste Abmessung eines Strukturelements in vertikaler Richtung, das heißt parallel zur Wachstumsrichtung, zu verstehen. Unter der "Breite" ist die längste Abmessung eines Strukturelements in einer ersten lateralen Richtung senkrecht zur Wachstumsrichtung zu verstehen.

Bei einem kreisförmigen Querschnitt entspricht die längste Abmessung in der ersten lateralen Richtung dem Durchmesser. Es ist auch möglich, dass die Strukturelemente langgestreckt, beispielsweise rechteckförmig, sind. Beispielsweise können rechteckförmige Strukturelemente eine Breite zwischen 1 μm und 20 μm und eine Länge zwischen 320 μm und 1000 μm aufweisen. Hierbei entspricht die "Länge" der Strukurelemente der längsten Abmessung in einer zweiten lateralen Richtung, die senkrecht zur ersten lateralen Richtung verläuft. Eine bevorzugte Länge liegt auch hier im Bereich von λ/n, vorzugsweise von höchstens λ/n.

Der Brechungsindex n bezeichnet einen mittleren Brechungsindex, der sich aus den verschiedenen Brechungsindizes der im Halbleiterchip befindlichen Materialien, mit welchen die Strahlung wechselwirkt, errechnet.

Die Strukturelemente können in regelmäßigen oder unregelmäßigen Abständen über die Aufwachsoberfläche verteilt sein. In den Ausführungsformen der Erfindung sind die Abstände unregelmäßig. Die Art der Verteilung kann durch die zur Herstellung der Strukturelemente verwendete Methode vorgegeben sein. Beispielsweise kann durch Fotolithografie eine regelmäßige Struktur erzeugt werden, während mittels natürlicher Lithographie, bei welcher zufällig verteilte aufgesprühte Kügelchen als Maske dienen, eine unregelmäßige Struktur hergestellt wird.

Unabhängig von der Art der Verteilung ist es vorteilhaft, wenn die Abstände zwischen den Strukturelementen Werte von wenigen Nanometern bis zu einigen Mikrometern nicht überschreiten.

Typischerweise wird die Aufwachsschicht selbst auf einem Substrat aufgewachsen, bevor die aktive Zone auf der Aufwachsschicht angeordnet wird. Vorzugsweise ist die Aufwachsschicht zwischen der aktiven Zone und dem Substrat angeordnet und ist Teil eines zweiten Halbleiterbereichs.

Geeignete Substrate für das Wachstum der Aufwachsschicht und der aktiven Zone sind insbesondere GaN-, AlN-, SiC- oder Saphirsubstrate. Hierbei kann bei einem Indiumgehalt von mindestens 15% eine Gitterfehlanpassung f von mindestens 2% auftreten. Weitere geeignete Substrate enthalten beispielsweise InGaN oder ZnO oder bestehen daraus. Hierbei kann bei einem Indiumgehalt von mindestens 15% eine Gitterfehlanpassung f von höchstens 2% auftreten.

Die Gitterfehlanpassung f berechnet sich wie folgt:

$$f = [\text{Gitterkonstante(aktive Zone)} - \text{Gitterkonstante(Substrat)}] / \text{Gitterkonstante(Substrat)}.$$

Mittels der vorliegend beschriebenen Aufwachsschicht, die an der Aufwachsoberfläche Strukturelemente aufweist, ist es vorteilhafterweise möglich, störenden Kristalldefekten entgegen zu wirken, die ohne strukturierte Aufwachsschicht durch die Gitterfehlanpassung f hervorgerufen würden. Durch die Strukturierung der Aufwachsschicht wächst die aktive Zone nicht planar zweidimensional auf. Vielmehr kann mittels Strukturierung die Aufwachsoberfläche vergrößert und ein dreidimensionales, verspannungsarmes Wachstum der aktiven Zone erzielt werden.

Je größer die Gitterfehlanpassung f zwischen Substrat und aktiver Zone ist, desto größer sollte die Dichte der Strukturelemente und desto kleiner deren Breite gewählt werden.

Ist die Gitterfehlanpassung f zwischen Substrat und aktiver Zone kleiner als 2%, wie zum Beispiel bei der Verwendung von InGaN-Template-Substraten oder ZnO-Substraten, kann die Dichte der Strukturelemente reduziert und deren Breite vergrößert werden. Im Extremfall, wenn die Gitterfehlanpassung f zwischen Substrat und aktiver Zone kleiner als 0,5% wird, können die Strukturelmente so breit ausgebildet werden, dass die Aufwachsoberfläche annähernd planar ist.

Vorzugsweise werden vorliegend Substrate verwendet, bei welchen die Gitterfehlanpassung f zwischen Substrat und aktiver Zone mindestens 0.5% beträgt.

Die vorliegende Patentanmeldung umfasst alle Formen von Lumineszenzdioden, die kohärente und/oder inkohärente Strahlung emittieren. Die Lumineszenzdioden umfassen Leuchtdioden (LEDs) und Laserdiodenchips wie VECSEL, VCSEL oder Kantenemitter.

In Falle eines Laserdiodenchips kann beispielsweise eine an die aktive Zone angrenzende erste Wellenleiterschicht mit den Strukturelementen versehen sein.

Gemäß einer bevorzugten Variante eines Verfahrens zur Herstellung eines wie oben beschriebenen optoelektronischen Halbleiterchips wird eine nicht planare Aufwachsschicht ausgebildet, die mindestens ein erstes Nitridverbindungshalbleitermaterial enthält und an einer Aufwachsoberfläche Strukturelemente aufweist. Weiterhin wird eine aktive Zone, die mindestens ein zweites Nitridverbindungshalbleitermaterial enthält, auf der Aufwachsschicht angeordnet. Außerdem wird eine Deckschicht ausgebildet, die ein transparentes leitendes Oxid enthält.

Zur Herstellung der nicht planaren Aufwachsschicht wird vorzugsweise eine planare Halbleiterschicht, die mindestens ein erstes Nitridverbindungshalbleitermaterial enthält, strukturiert. Besonders bevorzugt erfolgt die Strukturierung mittels Fotolithographie, natürlicher Lithographie, Elektronenstrahllithographie, Nano-imprint, nasschemischem Ätzen oder Trockenätzen. Die dadurch erzeugten Strukturelemente können über die Aufwachsoberfläche regelmäßig oder unregelmäßig verteilt sein. Die Strukturelemente können insbesondere Erhebungen sein, die beispielsweise eine halbkugelförmige, zylinderförmige, pyramidenförmige oder langgestreckte, beispielsweise rechteckförmige, Gestalt aufweisen. Es ist jedoch auch möglich, dass die Strukturelemente Vertiefungen sind, die beispielsweise Löchern, Mulden oder Gräben gleichen.

Bei einer weiteren bevorzugten Ausführungsform wird die nicht planare Aufwachsschicht dadurch erzeugt, dass ein Nitridverbindungshalbleitermaterial wie zum Beispiel GaN oder InGaN bei einer vergleichsweise niedrigen Wachstumstemperatur von höchstens 850 °C aufgebracht wird. Bei einer derart geringen Wachstumstemperatur bildet sich keine annähernd glatte Schicht wie bei der herkömmlichen epitaktischen Abscheidung, sondern eine Schicht mit einer rauen Oberflächenstruktur aus. Somit wird bei dieser Ausführungsform die Strukturierung der Aufwachsschicht bereits durch die verringerte Wachstumstemperatur bei der Abscheidung erzielt und eine weitere Strukturierung ist vorteilhaft nicht notwendig.

Das Aufwachsen der Aufwachsschicht und der aktiven Zone auf das Substrat kann mittels metallorganischer Gasphasenepitaxie (MOVPE) oder Molekularstrahlepitaxie (MBE) erfolgen.

Im folgenden werden der oben beschriebene optoelektronische Halbleiterchip und das Verfahren anhand der Figuren 1 bis 9 näher erläutert.

Es zeigen:

Figur 1    eine REM-Aufnahme eines ersten Ausführungsbeispiels einer Aufwachsoberfläche,

Figur 2    eine REM-Aufnahme eines zweiten Ausführungsbeispiels einer Aufwachsoberfläche,

Figur 3    eine Explosionsdarstellung eines Schichtaufbaus eines optoelektronischen Halbleiterchips,

Figur 4    eine schematische Querschnittsansicht eines Teils des in Figur 3 dargestellten Schichtaufbaus,

Figur 5    ein Schaubild darstellend eine simulierte vertikale optische Mode in einem Laserdiodenchip gemäß einem ersten Ausführungsbeispiel,

Figur 6    ein Schaubild darstellend eine simulierte vertikale optische Mode in einem Laserdiodenchip gemäß einem zweiten Ausführungsbeispiel,

Figur 7    eine schematische Querschnittsansicht eines Laserdiodenchips entsprechend eines ersten Designs,

Figur 8    eine schematische Querschnittsansicht eines Laserdiodenchips entsprechend eines zweiten Designs,

Figur 9    eine schematische Querschnittsansicht eines Laserdiodenchips entsprechend eines dritten Designs.

Gleiche oder gleichwirkende Elemente sind in den Figuren mit den gleichen Bezugszeichen versehen.

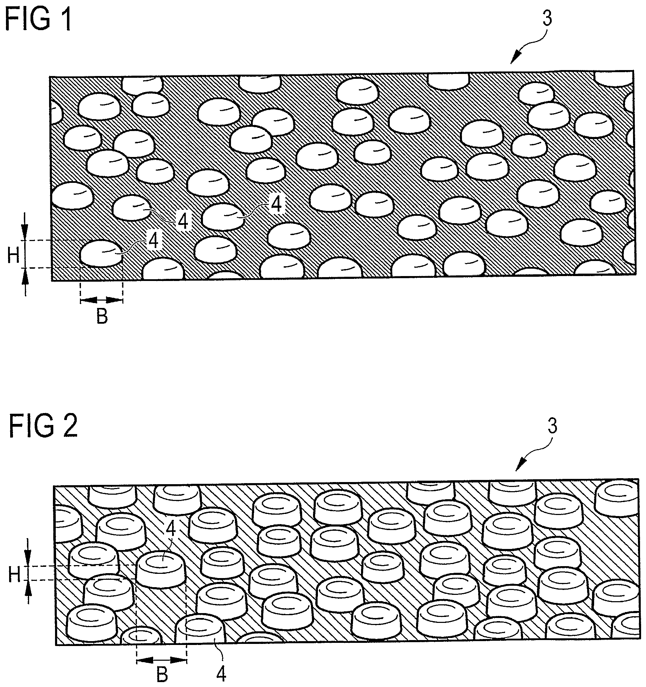

Figur 1 zeigt einen vergrößerten Ausschnitt der Aufwachsoberfläche 3 einer Aufwachsschicht gemäß einem ersten Ausführungsbeispiel. Hierbei weist die Aufwachsoberfläche 3 Strukturelemente 4 mit halbkugelförmiger Gestalt auf.

Die Höhe H und die Breite B eines jeweiligen Strukturelements 4 liegen im Bereich von $\lambda/n$ und übersteigen vorzugsweise diesen Wert nicht. Beispielsweise beträgt im abgebildeten Fall B ≈ 174 nm und H ≈ 62 nm. Die Strukturelemente 4 sind über die Aufwachsoberfläche 3 unregelmäßig verteilt. Eine derartige Verteilung ergibt sich beispielsweise durch Anwendung der natürlichen Lithographie, bei welcher Polystyrolkügelchen auf eine zu strukturierende Schicht aufgebracht werden. Die Polystyrolkügelchen sind auf der Oberfläche der Schicht unregelmäßig verteilt. In den Zwischenräumen zwischen den Kügelchen wird die Schicht geätzt. Unter den Polystyrolkügelchen entstehen so die unregelmäßig verteilten Strukturelemente 4.

Die Abstände zwischen den Strukturelementen 4 sind vorzugsweise nicht größer als wenige Nanometer bis zu einigen Mikrometern.

Figur 2 zeigt ein weiteres Ausführungsbeispiel einer Aufwachsoberfläche 3. Hierbei sind die Strukturelemente 4 zylinderförmig beziehungsweise pyramidenstumpfförmig ausgebildet. Die Breite kann B ≈ 290 nm und die Höhe H ≈ 88 nm betragen.

Sowohl die in Figur 1 als auch die in Figur 2 dargestellten Strukturelemente 4 tragen zu einer Vergrößerung der Oberfläche der Aufwachsschicht bei, so dass auf der Aufwachsschicht Indium-reiche Schichten abgeschieden werden können, die weniger verspannt sind und daher eine geringere Defektdichte aufweisen.

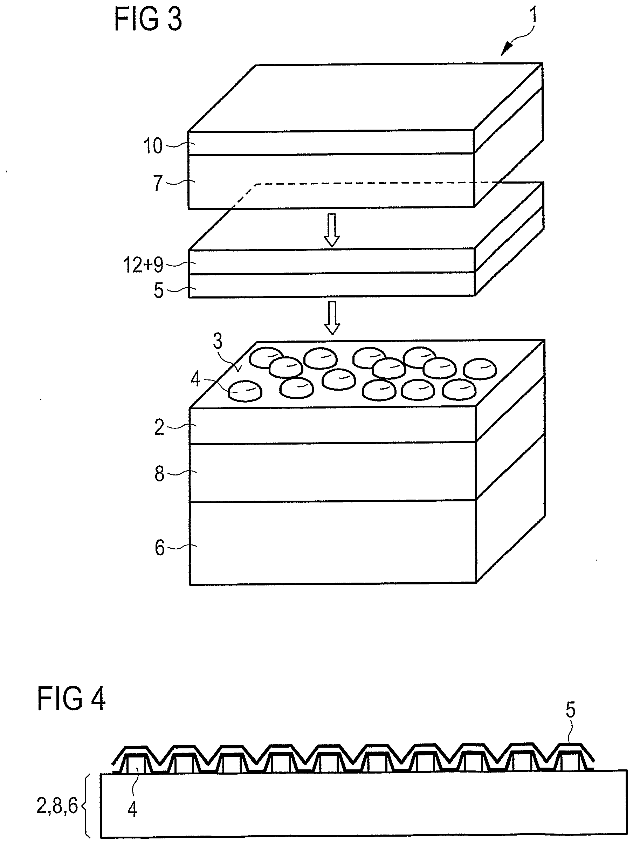

Figur 3 zeigt den Schichtaufbau eines optoelektronischen Halbleiterchips 1. Auf einem Substrat 6 ist eine Aufwachsschicht 2 angeordnet, die auf einer dem Substrat 6 zugewandten Seite planar ist und auf einer dem Substrat 6 abgewandten Seite eine Aufwachsoberfläche 3 mit einer Vielzahl von Strukturelementen 4 aufweist. Auf der Aufwachsschicht 2 wird die aktive Zone 5 angeordnet, die insbesondere eine Quantenstruktur aufweist.

Das Substrat 6 kann beispielsweise GaN, AlN, SiC oder Saphir enthalten oder daraus bestehen. Die Aufwachsschicht 2 enthält mindestens ein erstes Nitridverbindunghalbleitermaterial der oben genannten Art, vorzugsweise GaN und/oder InGaN. Die aktive Zone 5 enthält mindestens ein zweites Nitridverbindunghalbleitermaterial mit einem Indiumanteil von mindestens 15%. Ein derartiger Indiumanteil ermöglicht die Erzeugung von Strahlung mit einer Wellenlänge im kurzwelligen sichtbaren Spektralbereich, insbesondere im grünen Spektralbereich mit einer Wellenlänge größer 435 nm.

Die aktive Zone 5 kann direkt auf der Aufwachsschicht 2 abgeschieden werden. Es ist jedoch auch möglich, dass mindestens eine Schicht zwischen der Aufwachsschicht 2 und der aktiven Zone 5 angeordnet ist. Mit Vorteil ist der Abstand zwischen der aktiven Zone 5 und der Aufwachsschicht 2 einerseits so groß gewählt, dass durch die Strukturelemente 4 keine Beschädigungsgefahr für die aktive Zone 5 besteht, und ist andererseits so klein gewählt, dass sich die nicht planare Geometrie bis in die aktive Zone 5 fortsetzt.

Wie in der Figur 4 erkennbar ist, bewirkt die nicht planare Geometrie der Aufwachsschicht 2, dass die aktive Zone 5 sowohl auf einer der Aufwachsschicht 2 zugewandten Seite als auch auf einer der Aufwachsschicht 2 abgewandten Seite eine nicht planare Oberfläche aufweist. Durch die vergrößerte Oberfläche kann die kompressive Verspannung abgebaut werden.

Die aktive Zone 5 weist keine Unterbrechungen auf. Ebenso kann die Aufwachsschicht 2 durchgehend ausgebildet sein. Über die gesamte Aufwachsoberfläche 3 hinweg können Kristallfacetten in kristallspezifischen Winkeln ausgebildet werden.

Bei dem in Figur 3 dargestellten Ausführungsbeispiel werden auf dem Substrat 6 zunächst eine erste Mantelschicht 8, die vorzugsweise GaN, AlGaN oder AlInGaN enthält und n-dotiert ist, und eine erste Wellenleiterschicht 2, die vorzugsweise GaN oder InGaN enthält und n-dotiert ist, abgeschieden. Insbesondere ist der Brechungsindex der ersten Mantelschicht 8 kleiner als der Brechungsindex der ersten Wellenleiterschicht 2.

Die erste Wellenleiterschicht wird an der Oberfläche strukturiert, so dass die Strukturelemente 4 entstehen. Die erste Wellenleiterschicht 2 bildet dann zugleich die Aufwachsschicht 2.

Anschließend wird die Aufwachsschicht 2 überwachsen. Es werden die aktive Zone 5, eine zweite Wellenleiterschicht 9, die vorzugsweise GaN oder InGaN enthält und p-dotiert ist, und eine Kontaktschicht 12 abgeschieden.

Ein erster Halbleiterbereich umfasst die Wellenleiterschicht 9 und die Kontaktschicht 12. Ein zweiter Halbleiterbereich umfasst die Aufwachsschicht 2 und die Mantelschicht 8.

Auf den ersten Halbleiterbereich wird eine Deckschicht 7, die vorzugsweise eine Mantelschicht aus Halbleitermaterial ersetzt, aufgebracht. Die Deckschicht 7 enthält mit Vorteil ein TCO, wodurch im Vergleich zu einer Mantelschicht aus Halbleitermaterial die Kristallqualität verbessert und die Herstellungszeit verkürzt werden kann.

Auf der Deckschicht 7 wird schließlich ein Metallkontakt 10 angeordnet.

In Summe tragen alle Maßnahmen, wie die Ausbildung der Aufwachsschicht 2 mit Strukturelementen 4 und der Deckschicht 7 aus TCO, zur Verringerung der Verspannung bei. Dies hat neben der Qualitätsverbesserung den Vorteil geringerer Piezobarrieren. Aufgrund geringerer Piezobarrieren kann vorliegend auch in polaren Kristallrichtungen (zum Beispiel c-Achse) ein Wachstum stattfinden.

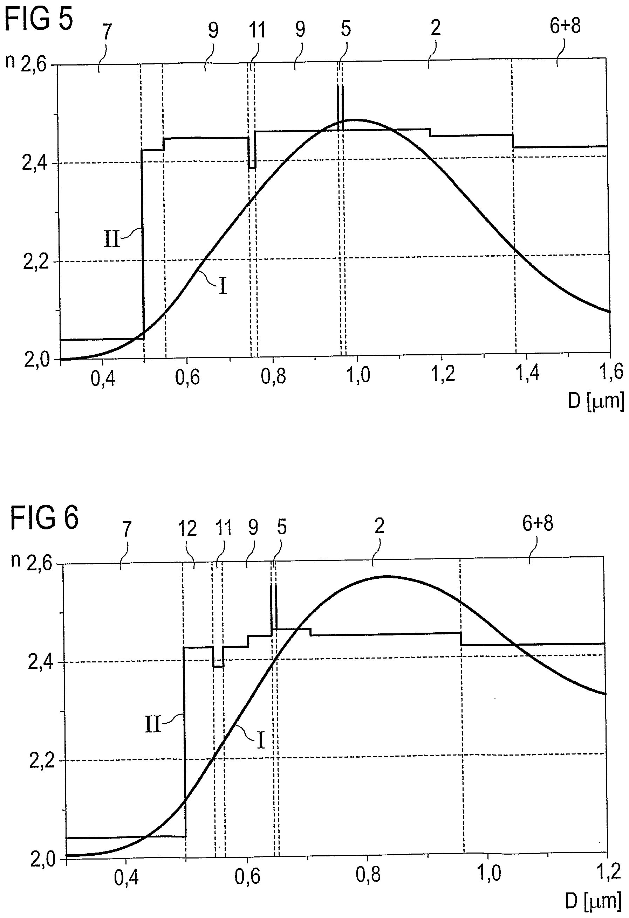

Die Schaubilder der Figuren 5 und 6 zeigen simulierte vertikale optische Moden für verschiedene Designs eines Laserdiodenchips. Die Laserdiodenchips sind vom Prinzip her wie in Figur 3 dargestellt aufgebaut. Allerdings ist die Wellenführung auf verschiedene Weise optimiert.

Die Kurve I stellt jeweils die simulierte vertikale optische Mode und die Kurve II den Verlauf des Brechungsindex n dar.

Dem Schaubild der Figur 5 wird ein Laserdiodenchip zugrunde gelegt, der ein Substrat 6 aus n-GaN und eine darauf angeordnete erste Mantelschicht 8 aufweist, die n-GaN und/oder n-AlGaN enthält. Der Brechungsindex n ist kleiner als in der aktiven Zone 5 oder der angrenzenden Wellenleiterschicht 2.

Die Wellenleiterschicht 2 weist eine Dicke D von etwa 400 nm und einen räumlich variierenden, insbesondere stufenförmig verlaufenden, Brechungsindex n auf. Die Wellenleiterschicht 2 kann InGaN mit räumlich variierendem Indiumanteil enthalten. Vorzugsweise ist die Wellenleiterschicht 2 n-dotiert.

Auf die Wellenleiterschicht 2 folgt die aktive Zone 5, die eine Dicke D von etwa 25 nm und einen alternierenden Brechungsindex n aufweist. Insbesondere weist die aktive Zone 5 eine Quantenstruktur auf.

An die aktive Zone 5 schließen sich eine zweite Wellenleiterschicht 9, innerhalb welcher eine Elektronenstoppschicht 11 angeordnet ist, sowie eine Kontaktschicht 12 und eine Deckschicht 7 an.

Die Wellenleiterschicht 9 weist eine Dicke D von annähernd 400 nm und einen räumlich variierenden Brechungsindex n auf, der zur Kontaktschicht 12 hin kleiner wird. Vorzugsweise ist die Wellenleiterschicht 9 p-dotiert und enthält InGaN/GaN.

Die Kontaktschicht 12 mit einer Dicke D von 50 nm enthält vorzugsweise p-GaN und weist einen Brechungsindex n auf, der kleiner ist als in der Wellenleiterschicht 9.

In der Deckschicht 7, die insbesondere ein TCO enthält und als Mantelschicht dient, ist der Brechungsindex n relativ gering. Dies ermöglicht eine gute Wellenführung und eine gute Abschirmung von dem Metallkontakt 10 (vgl. Figur 3). Bei genügend kleinem Kontaktwiderstand ($\sim 10^{-4}$ Ohm/cm$^2$) und Schichtwiderstand der Deckschicht 7 können aufgrund relativ geringer Verlustleistungen im Betrieb die Lebensdauer und die Ausgangsleistung gegenüber einem herkömmlichen Laserdiodenchip mit einer Mantelschicht aus Halbleitermaterial gesteigert werden.

Der dem Schaubild der Figur 6 zugrunde liegende Laserdiodenchip unterscheidet sich hauptsächlich in der Dicke D der zweiten Wellenleiterschicht 9 von dem vorgenannten Ausführungsbeispiel. Die Dicke D ist hierbei dünner gewählt. Die Herstellung der p-Seite, die typischerweise bei Temperaturen erfolgt, welche die Diffusion von Indium aus der aktiven Zone begünstigen, ist damit weniger zeitintensiv. Folglich kann durch die eingeschänkte thermische Belastung die Qualität der aktiven Zone verbessert werden. Dieser Vorteil gleicht den Nachteil des geringeren Füllfaktors aus.

Zusammenfassend kann im Bezug auf die Figuren 5 und 6 gesagt werden, dass für die zugrunde liegenden Laserdiodenchips vorwiegend InGaN-haltige Wellenleiterschichten mit einem höheren Brechungsindex als GaN verwendet wurden. Dies ermöglicht vorteilhafterweise den Einsatz von GaN-Mantelschichten oder relativ dünnen AlGaN-Mantelschichten und vermeidet das Problem der Verspannung, wie es bei dickeren AlGaN-Mantelschichten auftreten kann, die bei herkömmlichen GaN-basierenden Laserstrukturen verwendet werden.

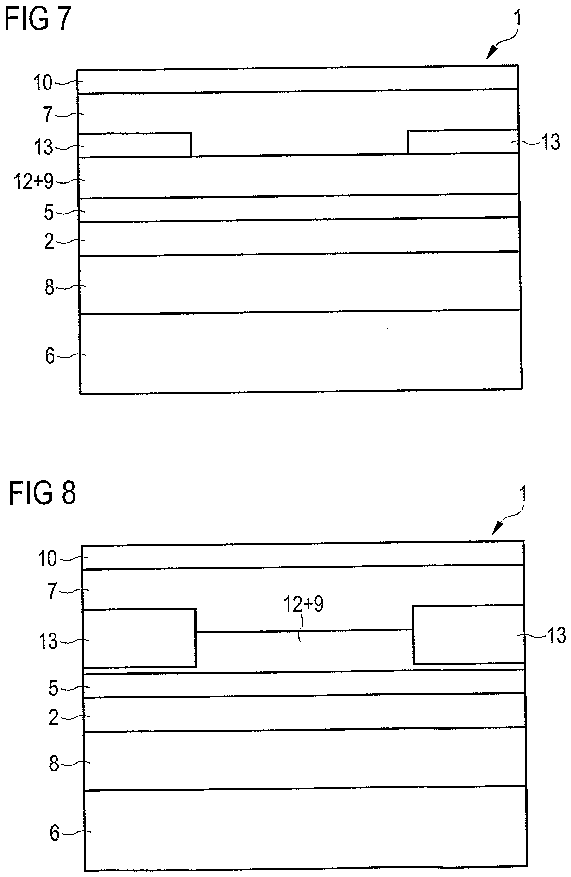

Die Figuren 7 bis 9 zeigen verschiende Ausführungsbeispiele eines optoelektronischen Halbleiterchips 1. Alle Ausführungsbeispiele stellen Laserdiodenchips dar, die vorzugsweise grünes Licht emittieren.

Die optoelektronischen Halbleiterchips 1 weisen insbesondere einen wie im Zusammenhang mit den Figuren 3, 5 und 6 erläuterten Schichtaufbau auf.

In den Halbleiterchips 1 der Figuren 7 bis 9 ist eine in der Mitte unterbrochene Passivierungsschicht 13 vorgesehen, die den Stromfluss auf eine schmale Streifenregion begrenzt.

Bei dem Ausführungsbeispiel der Figur 7 sind Wellenleiter- und Kontaktschicht 9, 12 ganzflächig ausgebildet. Die Passivierungsschicht 13 ist auf der Wellenleiter- und Kontaktschicht 9, 12 angeordnet und wird von der TCO enthaltenden Deckschicht 7 bedeckt, welche außerdem die Streifenregion ausfüllt. Auf der Deckschicht 7 ist ein ganzflächiger Metallkontakt 10 angeordnet.

Der dargestellte Laserdiodenchip kann als gewinngeführter Laser arbeiten. Durch die Wahl der Passivierungsschicht 13 mit niedrigerem Brechungsindex als die Deckschicht 7 kann jedoch auch eine laterale Brechungsindexführung erfolgen, wodurch die Laserschwelle und die Strahleigenschaften verbessert werden können.

Der in Figur 8 dargestellte Laserdiodenchip weist eine streifenförmig geätzte Wellenleiter- und Kontaktschicht 9, 12 auf, deren Seitenflächen von der Passivierungsschicht 13 bedeckt sind. Die aktive Zone 5 muss hierbei nicht geätzt werden. Denn durch die Wahl der Passivierungsschicht 13 mit niedrigerem Brechungsindex als die Deckschicht 7, welche auf der Passivierungsschicht 13 und in der Streifenregion angeordnet ist, kann eine hinreichend gute laterale Brechungsindexführung stattfinden. Die Deckschicht 7 ist mit einem ganzflächigen Metallkontakt 10 überzogen.

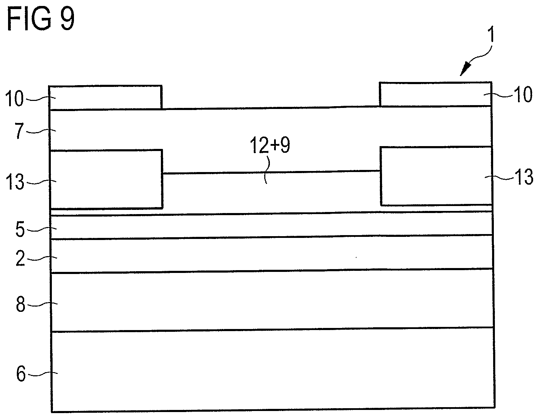

Bei dem in Figur 9 dargestellten Laserdiodenchip ist der Metallkontakt 10 in der Streifenregion geöffnet. Dies ermöglicht die Verwendung einer dünnen Deckschicht 7, ohne dabei Absorption am darüberliegenden Metallkontakt 10 zu riskieren. Dieses Design ermöglicht außerdem ein optisches Pumpen des Laserdiodenchips, wobei das Pumplicht effizient in der aktiven Zone 5 und den Wellenleiterschichten 2, 9 absorbiert werden kann. Das optische Pumpen ist für eine effiziente Ladungstägerinjektion in die aktive Zone 5 insbesondere bei einem Laserdiodenchip, der grünes Licht emittiert, vorteilhaft, um die Injektionsprobleme beim vertikalen elektrischen Ladungsträgertransport zu vermeiden. Die Erfindung ist nicht durch die Beschreibung anhand der Ausführungsbeispiele beschränkt. Vielmehr umfasst die Erfindung jedes Merkmal sowie jede Kombination von Merkmalen in den Patentansprüchen.

**Patentansprüche**

1. Optoelektronischer Halbleiterchip (1) mit

- einem Substrat (6),
- einer Mantelschicht (8) auf dem Substrat (6),
- einer nicht planaren Aufwachsschicht (2), die mindestens ein erstes Nitridverbindungshalbleitermaterial enthält und die sich auf der Mantelschicht (8) befindet,
- einer aktiven Zone (5), die mindestens ein zweites Nitridverbindungshalbleitermaterial enthält und auf der Aufwachsschicht (2) angeordnet ist,
- einer Deckschicht (7), die auf der aktiven Zone (5) angeordnet ist und ein transparentes leitendes Oxid enthält, und
- einem ersten Halbleiterbereich (9, 12), der zwischen der aktiven Zone (5) und der Deckschicht (7) angeordnet ist,

wobei

- die Aufwachsschicht (2) an einer der aktiven Zone (5) zugewandten Aufwachsoberfläche (3) Strukturelemente (4) aufweist und auf einer der Aufwachsoberfläche (3) gegenüber liegenden Seite planar ausgebildet ist,
- die Strukturelemente (4) unregelmäßig über die Aufwachsoberfläche (3) verteilt sind,
- sich eine durch die Strukturelemente (4) bedingte nicht planare Geometrie der Aufwachsschicht (2) bis in die aktive Zone (5) fortsetzt, sodass die aktive Zone (5) eine durch die Strukturelemente (4) bestimmte nicht planare Gestalt aufweist, und
- die aktive Zone (5) keine Unterbrechungen aufweist und die Aufwachsschicht (2) durchgehend ausgebildet ist.

2. Optoelektronischer Halbleiterchip (1) nach Anspruch 1, wobei das zweite Nitridverbindungshalbleitermaterial ein $In_{1-x-y}Al_xGa_yN$ mit $0 \leq x < 1$, $0 \leq y < 1$ und $1-x-y \geq 0{,}15$ ist.

3. Optoelektronischer Halbleiterchip (1) nach einem der vorhergehenden Ansprüche, wobei die aktive Zone (5) Strahlung mit einer Wellenlänge $\lambda$ von 435 nm oder größer emittiert.

4. Optoelektronischer Halbleiterchip (1) nach einem der vorhergehenden Ansprüche, wobei die Strukturelemente (4) eine Höhe (H) und Breite (B) von höchstens $\lambda/n$ aufweisen, wobei n der Brechungsindex und $\lambda$ die Wellenlänge der von der aktiven Zone (5) emittierten Strahlung ist.

5. Optoelektronischer Halbleiterchip (1) nach einem der vorhergehenden Ansprüche, wobei das erste Nitridverbindungshalbleitermaterial ein $In_{1-x-y}Al_xGa_yN$ mit $0 \leq x \leq 1$, $0 \leq y \leq 1$ und $x+y \leq 1$ ist.

6. Optoelektronischer Halbleiterchip (1) nach einem der vorhergehenden Ansprüche, wobei die aktive Zone (5) eine durch die Strukturelemente (4) bestimmte nicht planare Gestalt aufweist.

7. Optoelektronischer Halbleiterchip (1) nach einem der vorhergehenden Ansprüche, wobei direkt auf der Deckschicht (7) ein ganzflächiger Metallkontakt (10) angeordnet ist, wobei die Deckschicht (7) als Mantelschicht dient, die eine Mantelschicht aus Halbleitermaterial ersetzt.

8. Optoelektronischer Halbleiterchip (1) nach einem der vorhergehenden Ansprüche, wobei eine Gitterfehlanpassung f zwischen dem Substrat (6) und der aktiven Zone (5) mindestens 0.5% beträgt.

9. Optoelektronischer Halbleiterchip (1) nach einem der vorhergehenden Ansprüche, wobei das Substrat (6) GaN, AlN, SiC, Saphir, InGaN oder ZnO enthält.

10. Optoelektronischer Halbleiterchip (1) nach einem der vorhergehenden Ansprüche, wobei der erste Halbleiterbereich (9, 12) eine Dicke zwischen mindestens 2 nm und höchstens 300 nm aufweist, wobei der erste Halbleiterbereich eine Wellenleiterschicht (9) und eine Kontaktschicht (12) umfasst.

11. Verfahren zur Herstellung eines optoelektronischen Halbleiterchips (1) gemäß einem der Ansprüche 1 bis 10 mit den Schritten:

   - Ausbilden einer nicht planaren Aufwachsschicht (2), die mindestens ein erstes Nitridverbindungshalbleitermaterial enthält und an einer Aufwachsoberfläche (3) Strukturelemente (4) aufweist,
   - Anordnen einer aktiven Zone (5), die mindestens ein zweites Nitridverbindungshalbleitermaterial enthält, auf der Aufwachsschicht (2),
   - Ausbilden einer Deckschicht (7), die ein transparentes leitendes Oxid enthält.

12. Verfahren nach Anspruch 11, wobei die Aufwachsschicht (2) bei einer Temperatur von weniger als 850°C hergestellt wird, oder wobei Polystyrolkügelchen auf die zu strukturierende Aufwachsschicht (2) aufgebracht werden und die Polystyrolkügelchen dabei unregelmäßig auf einer Oberfläche der Aufwachsschicht (2) verteilt sind, wobei in Zwischenräumen zwischen den Polystyrolkügelchen die Aufwachsschicht (2) geätzt wird, sodass unter den Polystyrolkügelchen die unregelmäßig verteilten Strukturelemente (4) entstehen.

13. Verfahren nach Anspruch 11, wobei die Strukturelemente (4) mittels Fotolithographie, natürlicher Lithographie, Elektronenstrahllithographie, Nano-imprint, nasschemischem Ätzen oder Trockenätzen hergestellt werden.

**Claims**

1. Optoelectronic semiconductor chip (1) with

   - a substrate (6),
   - a cladding layer (8) on the substrate (6),
   - a non-planar growth layer (2), which contains at least one first nitride compound semiconductor material and is located on the cladding layer (8),
   - an active zone (5), which contains at least one second nitride compound semiconductor material and is arranged on the growth layer (2),
   - a top layer (7), which is arranged on the active zone (5) and contains a transparent conductive oxide, and
   - a first semiconductor region (9, 12), which is arranged between the active zone (5) and the top layer (7),

   wherein

   - the growth layer (2) comprises structure elements (4) on a growth surface (3) facing the active zone (5) and is formed planar on a side lying opposite the growth surface (3),
   - the structure elements (4) are distributed unevenly over the growth surface (3),
   - a non-planar geometry of the growth layer (2) caused by the structure elements (4) continues into the active zone (5), so that the active zone (5) has a non-planar form determined by the structure elements (4), and
   - the active zone (5) has no interruptions and the growth layer (2) is formed continuously.

2. Optoelectronic semiconductor chip (1) according to claim 1, wherein the second nitride compound semiconductor material is an $In_{1-x-y}Al_xGa_yN$ with $0 \leq x < 1$, $0 \leq y < 1$ and $1-x-y \geq 0.15$.

3. Optoelectronic semiconductor chip (1) according to any one of the preceding claims, wherein the active zone (5) emits radiation with a wavelength $\lambda$ of 435 nm or greater.

4. Optoelectronic semiconductor chip (1) according to any one of the preceding claims, wherein the structure elements (4) have a height (H) and width (B) of at most $\lambda/n$, wherein n is the refractive index and $\lambda$ the wavelength of the radiation emitted by the active zone (5).

5. Optoelectronic semiconductor chip (1) according to any one of the preceding claims, wherein the first nitride compound semiconductor material is an $In_{1-x-y}Al_xGa_yN$ with $0 \leq x \leq 1$, $0 \leq y \leq 1$ and $x+y \leq 1$.

6. Optoelectronic semiconductor chip (1) according to any one of the preceding claims, wherein the active zone (5) has a non-planar form determined by the structure elements (4).

7. Optoelectronic semiconductor chip (1) according to any one of the preceding claims, wherein an all-over metal contact (10) is arranged directly on the top layer (7), wherein the top layer (7) serves as cladding layer, which replaces a cladding layer of semiconductor material.

8. Optoelectronic semiconductor chip (1) according to any one of the preceding claims, wherein a lattice mismatch f between the substrate (6) and the active zone (5) amounts to at least 0.5%.

9. Optoelectronic semiconductor chip (1) according to any one of the preceding claims, wherein the substrate (6) contains GaN, AlN, SiC, sapphire, InGaN or ZnO.

10. Optoelectronic semiconductor chip (1) according to any one of the preceding claims, wherein the first semiconductor region (9, 12) has a thickness of between at least 2 nm and at most 300 nm, wherein the first semiconductor region comprises a waveguide layer (9) and a contact layer (12).

11. Method of producing an optoelectronic semiconductor chip (1) according to any one of claims 1 to 10, having the steps:

    - formation of a non-planar growth layer (2), which contains at least one first nitride compound semiconductor material and comprises structure elements (4) on a growth surface (3),
    - arranging an active zone (5), which contains at least one second nitride compound semiconductor material, on the growth layer (2),

- formation of a top layer (7), which contains a transparent conductive oxide.

12. Method according to claim 11, wherein the growth layer (2) is produced at a temperature of less than 850°C, or wherein polystyrene beads are placed onto the growth layer (2) to be structured and the polystyrene beads are distributed unevenly on a surface of the growth layer (2), wherein the growth layer is etched in gaps between the polystyrene beads, so that the unevenly distributed structure elements (4) are created under the polystyrene beads.

13. Method according to claim 11, wherein the structure elements (4) are produced by means of photolithography, natural lithography, electron beam lithography, nano imprinting, wet chemical etching or dry etching.

**Revendications**

1. Puce à semi-conducteur optoélectronique (1) avec

    - un substrat (6),
    - une couche de revêtement (8) sur le substrat (6),
    - une couche d'épitaxie non plane (2), laquelle contient au moins un premier matériau semi-conducteur à composé de nitrure et se trouve sur la couche de revêtement (8),
    - une zone active (5), laquelle contient au moins un deuxième matériau semi-conducteur à composé de nitrure et est disposée sur la couche d'épitaxie (2),
    - une couche de protection (7) disposée sur la zone active (5) et contenant un oxyde conducteur transparent, et
    - une première zone semi-conductrice (9, 12) disposée entre la zone active (5) et la couche de protection (7), dans laquelle
    - la couche d'épitaxie (2) présente, sur une surface d'épitaxie (3) dirigée vers la zone active (5), des éléments de structure (4) et est exécutée de manière plane sur un côté opposé à la surface d'épitaxie (3),
    - les éléments de structure (4) sont répartis de façon irrégulière sur la surface d'épitaxie (3),
    - une géométrie non plane de la couche d'épitaxie (2) induite par les éléments de structure (4) se prolonge jusque dans la zone active (5), de sorte que la zone active (5) présente une forme non plane déterminée par les éléments de structure (4), et
    - la zone active (5) ne présente aucune interruption et la couche d'épitaxie (2) est exécutée de façon continue.

2. Puce à semi-conducteur optoélectronique (1) selon la revendication 1, dans laquelle le deuxième matériau semi-conducteur à composé de nitrure est un $In_{1-x-y}Al_xGa_yN$ avec $0 \leq x < 1$, $0 \leq y < 1$ et $1-x-y \geq 0,15$.

3. Puce à semi-conducteur optoélectronique (1) selon l'une des revendications précédentes, dans laquelle la zone active (5) émet un rayonnement d'une longueur d'ondes $\lambda$ de 435 nm ou plus.

4. Puce à semi-conducteur optoélectronique (1) selon l'une des revendications précédentes, dans laquelle les éléments de structure (4) présentent une hauteur (H) et une largeur (B) maximale de $\lambda/n$, dans laquelle n est l'indice de réfraction et $\lambda$ la longueur d'onde du rayonnement émis par la zone active (5).

5. Puce à semi-conducteur optoélectronique (1) selon l'une des revendications précédentes, dans laquelle le premier matériau semi-conducteur à composé de nitrure est un $In_{1-x-y}Al_xGa_yN$ avec $0 \leq x \leq 1$, $0 \leq y \leq 1$ et $x+y \leq 1$.

6. Puce à semi-conducteur optoélectronique (1) selon l'une des revendications précédentes, dans laquelle la zone active (5) présente une forme non plane déterminée par les éléments de structure (4).

7. Puce à semi-conducteur optoélectronique (1) selon l'une des revendications précédentes, dans laquelle un contact métallique (10) de pleine surface est disposé directement sur la couche de protection (7), dans laquelle la couche de protection (7) sert de couche de revêtement qui remplace une couche de revêtement en matériau semi-conducteur.

8. Puce à semi-conducteur optoélectronique (1) selon l'une des revendications précédentes, dans laquelle une discordance de réseau f entre le substrat (6) et la zone active (5) s'élève au moins à 0,5%.

9. Puce à semi-conducteur optoélectronique (1) selon l'une des revendications précédentes, dans laquelle le substrat (6) contient GaN, AlN, SiC, saphir, InGaN ou ZnO.

**10.** Puce à semi-conducteur optoélectronique (1) selon l'une des revendications précédentes, dans laquelle la première zone semi-conductrice (9, 12) présente une épaisseur entre au minimum 2 nm et au maximum 300 nm, dans laquelle la première zone semi-conductrice englobe une couche guide d'ondes (9) et une couche de contact (12).

**11.** Procédé de fabrication d'une puce à semi-conducteur optoélectronique (1) selon l'une des revendications 1 à 10, avec les étapes :

- constitution d'une couche d'épitaxie non plane (2) contenant au moins un premier matériau semi-conducteur à composé de nitrure et présentant des éléments de structure (4) sur une surface d'épitaxie (3),
- disposition d'une zone active (5), laquelle contient au moins un deuxième matériau semi-conducteur à composé de nitrure, sur la couche d'épitaxie (2),
- constitution d'une couche de protection (7) contenant un oxyde conducteur transparent.

**12.** Procédé selon la revendication 11, dans lequel la couche d'épitaxie (2) est fabriquée à une température inférieure à 850°C, ou
dans lequel des billes de polystyrène sont apposées sur la couche d'épitaxie (2) à structurer et les billes de polystyrène sont réparties de façon irrégulière sur une surface de la couche d'épitaxie (2), dans lequel la couche d'épitaxie est gravée dans des espaces intermédiaires entre les billes de polystyrène, de sorte que les éléments de structure (4) répartis de façon irrégulière voient le jour sous les billes de polystyrène.

**13.** Procédé selon la revendication 11, dans lequel les éléments de structure (4) sont fabriqués par photolithographie, lithographie naturelle, lithographie par faisceau d'électrons, nano-imprint, gravure chimique humide ou gravure sèche.

EP 2 313 934 B1

FIG 1

3

4
4
4

H

B

FIG 2

3

4

H

B
4

12

FIG 3

1

10

7

12+9

5

3

4

2

8

6

FIG 4

5

2,8,6

4

FIG 5

FIG 6

EP 2 313 934 B1

FIG 7

10
7
13
12+9
5
2
8
6

1

13

FIG 8

10
7

12+9

13
5
2
8
6

1

13

15

FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008035784
- US 20060060833 A1
- US 20080149946 A
- WO 2007003684 A
- EP 1901357 A
- US 20050082544 A
- US 20050045894 A1